# EUROPEAN PATENT APPLICATION

(11) **EP 4 195 272 A1**
(43) Date of publication of application: **14.06.2023**
(21) Application number: 22206265.5
(22) Date of filing: 09.11.2022
(51) Int. Cl.: H01L 27/06, H01L 29/775, H10N 97/00

(54) **NANORIBBON-BASED CAPACITORS**

(30) Priority: 12.12.2021 US 202117548546
(71) Applicant: INTEL Corporation, Santa Clara, CA 95054 (US)
(72) Inventor: OSTERMAYR, Martin, 85457 Woerth (DE); SEIDEMANN, Georg, 84036 Landshut (DE); LUTZ, Walther, 85435 Erding (DE); ASSENMACHER, Joachim, 82008 Unterhaching (DE)
(74) Representative: 2SPL Patentanwälte PartG mbB

(57) **Abstract**

Capacitors based on stacks of nanoribbons and associated devices and systems are disclosed. In particular, a stack of at least two nanoribbons may be used to provide a two-terminal device referred to herein as a "nanoribbon-based capacitor," where one nanoribbon serves as a first capacitor electrode and another nanoribbon serves as a second capacitor electrode. Using portions of nanoribbon stacks to implement nanoribbon-based capacitors could provide an appealing alternative to conventional capacitor implementations because it would require only modest process changes compared to fabrication of nanoribbon-based FETs and because nanoribbon-based capacitors could be placed close to active devices. Furthermore, with a few additional process steps, nanoribbon-based capacitors may, advantageously, be extended to implement other circuit blocks such as nanoribbon-based BJTs or three-nanoribbon arrangements with a common connection between two anodes and a separate connection to a cathode.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIGS. 2A-2B provide perspective views of example integrated circuit (IC) devices implementing nanoribbon-based capacitors, according to some embodiments of the present disclosure.
FIG. 3 provides a perspective view of an example IC device extending a nanoribbon-based capacitor arrangement to a three-nanoribbon arrangement with a common connection between two of the three nanoribbons, according to some embodiments of the present disclosure.
FIG. 4 provides a perspective view of an example IC device extending a nanoribbon-based capacitor arrangement to realize a bipolar junction transistor (BJT) using a three-nanoribbon arrangement, according to some embodiments of the present disclosure.
FIG. 5 provides a flow diagram of an example method of manufacturing an IC device with one or more nanoribbon-based capacitors, according to some embodiments of the present disclosure.
FIG. 6 provides top views of, respectively, a wafer and dies that may include one or more IC devices implementing nanoribbon-based capacitors, in accordance with various embodiments.
FIG. 7 is a cross-sectional side view of an IC package that may include one or more IC devices implementing nanoribbon-based capacitors, in accordance with various embodiments.
FIG. 8 is a cross-sectional side view of an IC device assembly that may include one or more IC devices implementing nanoribbon-based capacitors, in accordance with various embodiments.
FIG. 9 is a block diagram of an example computing device that may include one or more IC devices implementing nanoribbon-based capacitors, in accordance with various embodiments.

### Detailed Description

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating nanoribbon-based capacitors, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar FETs such as double-gate transistors, trigate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surfaces. A confinement surface refers to a particular orientation of the channel surface that is confined by the gate field. Non-planar FETs potentially improve performance relative to transistors having a planar architecture, such as single-gate transistors.

Nanoribbon-based transistors (i.e., nanoribbon-based FETs) may be particularly advantageous for continued scaling of complementary metal-oxide-semiconductor (CMOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer) over which such a structure is provided. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A FET may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

Typically, nanoribbon-based transistor arrangements include stacks of nanoribbons, where each stack includes two or more nanoribbons extending substantially parallel to the support structure and stacked above one another over the support structure. Inventors of the present disclosure realized that such stacks of nanoribbons may serve additional functions. In particular, a stack of at least two nanoribbons may be used to provide a two-terminal device that is referred to herein as a "nanoribbon-based capacitor," where one nanoribbon serves as a first capacitor electrode and another nanoribbon (the nanoribbon that is closest to one face of the first nanoribbon) serves as a second capacitor electrode. Since capacitors are widely used circuit blocks, such nanoribbon-based capacitors may be useful in a plurality of semiconductor process and circuit design applications such as various memory technologies (e.g., in dynamic random-access memory (DRAM) or static random-access memory (SRAM)), voltage regulators, noise reduction, write/read assist circuits, power switches, and more. Conventional capacitors generally require additional process steps and masks and, therefore, increase integration costs as well as area on chip required to realize sufficient capacitance values. In addition, their integration typically requires separation of devices, distance to active devices, and device channel limitations in order to ensure the channel relaxation time. Using portions of nanoribbon stacks to implement nanoribbon-based capacitors as described herein could provide an appealing alternative to such conventional capacitor implementations because such an approach would require only modest process changes compared to fabrication of nanoribbon-based FETs and because nanoribbon-based capacitors could be placed closer to active devices (e.g., nanoribbon-based FETs) than conventional capacitors. Furthermore, with a few additional process steps, for stacks that include at least three nanoribbons, nanoribbon-based capacitors may, advantageously, be extended to implement other circuit blocks such as nanoribbon-based BJTs or three-nanoribbon arrangements with a common connection between two anodes and a separate connection to a cathode. As used herein, the term "nanoribbon-based capacitors" refers to not only capacitors themselves (i.e., passive electronic components with two terminals), but also to other electronic components that include nanoribbon-based capacitors in them, e.g., to other two-terminal devices such as three-nanoribbon arrangements with a common connection between two anodes and a separate connection to a cathode, or to three-terminal devices such as BJTs.

IC devices as described herein, in particular IC devices implementing nanoribbon-based capacitors, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. In some embodiments, IC devices as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC devices as described herein may be included in memory devices or circuits. In some embodiments, IC devices as described herein may be employed as part of a chipset for executing one or more related functions in a computer.

In the following detailed description, various aspects of the illustrative implementations will be described using terms commonly employed by those skilled in the art to convey the substance of their work to others skilled in the art. For example, a term "interconnect" may be used to describe any interconnect structure formed of an electrically conductive material for providing electrical connectivity to one or more components associated with an IC or/and between various such components. In general, the term "interconnect" may refer to both conductive lines (or, simply, "lines," also sometimes referred to as "traces" or "trenches") and conductive vias (or, simply, "vias"). In general, in context of interconnects, the term "conductive line" may be used to describe an electrically conductive element isolated by an insulator material (e.g., a low-k dielectric material) that is provided within the plane of an IC die (e.g., a support structure). Such conductive lines may be stacked into several levels, or several layers, of a metallization stack. On the other hand, the term "conductive via" may be used to describe an electrically conductive element that interconnects two or more conductive lines of different levels. To that end, a conductive via may be provided substantially perpendicularly to the plane of an IC die and may interconnect two conductive lines in adjacent levels or two conductive lines in not adjacent levels. A term "metallization stack" may be used to refer to a stack of one or more interconnects for providing connectivity to different circuit components of an IC chip. Sometimes, conductive lines and vias may be referred to as "metal lines" and "metal vias", respectively, to highlight the fact that these elements include electrically conductive materials such as metals.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

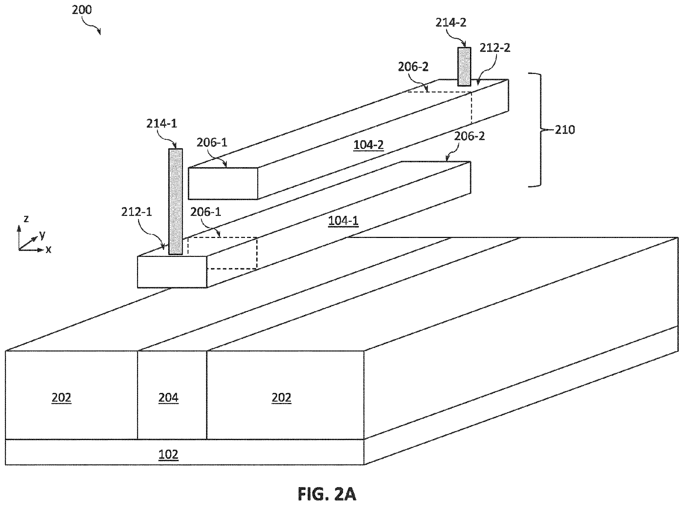

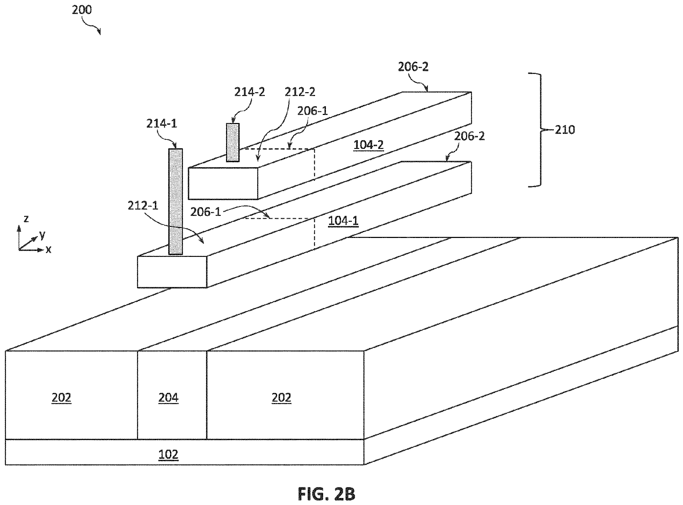

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 2A-2B, such a collection may be referred to herein without the letters, e.g., as "FIG. 2."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of nanoribbon-based capacitors as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

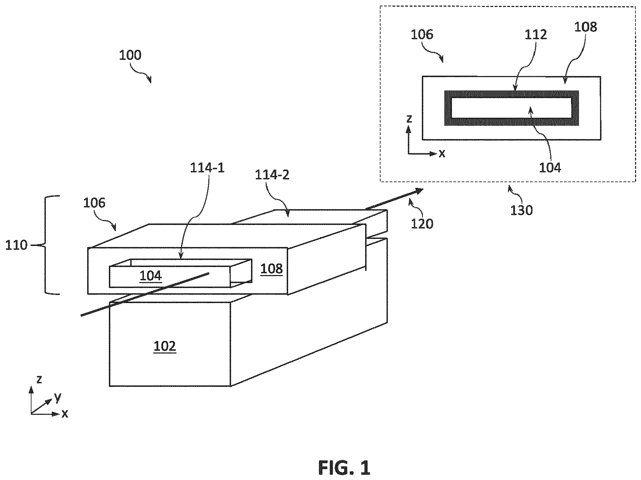

FIG. 1 provides a perspective view of an example IC device 100 with a nanoribbon-based transistor 110 (in particular, a FET), according to some embodiments of the present disclosure. In some embodiments, one or more of the nanoribbon-based transistors such as the transistor 110 may be formed along at least some of the nanoribbons based on which nanoribbon-based capacitors as described herein are also implemented. For example, in various embodiments, the transistor 110 formed on the basis of a nanoribbon 104, shown in FIG. 1, may be formed along any of the nanoribbons of the IC devices implementing nanoribbon-based capacitors as shown in FIGS. 2-4.

Turning to the details of FIG. 1, the IC device 100 may include a semiconductor material, which may include one or more semiconductor materials, formed as a nanoribbon 104 extending substantially parallel to the support structure 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first source or drain (S/D) region 114-1 and a second S/D region 114-2, on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2. In some embodiments, a layer of oxide material (not specifically shown in FIG. 1) may be provided between the support structure 102 and the gate stack 106.

The IC device 100 shown in FIG. 1, as well as IC devices shown in other drawings of the present disclosure, is intended to show relative arrangements of some of the components therein, and the IC device 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D electrode (which may also be referred to as a "first S/D contact") coupled to a first S/D region 114-1 of the transistor 110 and the gate stack 106 as well as between a second S/D electrode (which may also be referred to as a "second S/D contact") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

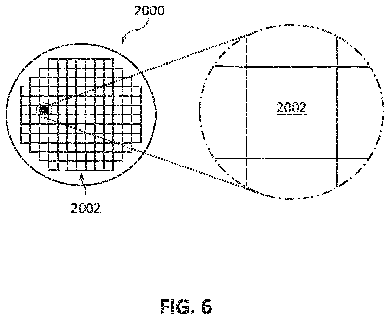

Implementations of the present disclosure may be formed or carried out on any suitable support structure 102, such as a substrate, a die, a wafer, or a chip. The support structure 102 may, e.g., be the wafer 2000 of FIG. 6, discussed below, and may be, or be included in, a die, e.g., the singulated die 2002 of FIG. 6, discussed below. The support structure 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure 102 may be a printed circuit board (PCB) substrate. Although a few examples of materials from which the support structure 102 may be formed are described here, any material that may serve as a foundation upon which an IC device implementing nanoribbon-based capacitors as described herein may be built falls within the spirit and scope of the present disclosure.

The nanoribbon 104 may take the form of a nanowire or nanoribbon, for example. In some embodiments, an area of a transversal cross-section of the nanoribbon 104 (i.e., an area in the x-z plane of the example coordinate system x-y-z shown in FIG. 1) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support structure 102 and in a direction perpendicular to a longitudinal axis 120 of the nanoribbon 104, e.g., along the y-axis of the example coordinate system shown in FIG. 1) may be at least about 3 times larger than a height of the nanoribbon 104 (i.e., a dimension measured in a plane perpendicular to the support structure 102, e.g., along the z-axis of the example coordinate system shown in FIG. 1), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon. For example, when a nanoribbon extends substantially parallel to a support structure (i.e., when the longitudinal axis of the nanoribbon is substantially parallel to the support structure), the term "face" of the nanoribbon refers to either one of the two sides of the nanoribbon that are substantially parallel to the support structure (i.e., both faces of a nanoribbon extend in directions parallel to the longitudinal axis of the nanoribbon, substantially parallel to the support structure, the side being closest to the support structure being the bottom face and the side being further away from the support structure being the top face), while the term "sidewall" of the nanoribbon refers to either one of the two sides of the nanoribbon that also extend in directions parallel to the longitudinal axis of the nanoribbon but substantially perpendicular to the support structure. On the other hand, the term "end" of a nanoribbon refers to either one of two portions of the nanoribbon that include sides of the nanoribbon that are substantially perpendicular to the longitudinal axis of the nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back end fabrication to avoid damaging other components, e.g., front end components such as the logic devices.

A gate stack 106 including a gate electrode material 108 and, optionally, a gate dielectric material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. The gate dielectric material 112 is not shown in the perspective drawing of the IC device 100 shown in FIG. 1, but is shown in an inset 130 of FIG. 1, providing a cross-sectional side view of a portion of the nanoribbon 104 with a gate stack 106 wrapping around it. As shown in FIG. 1, the gate dielectric material 112 may wrap around a transversal portion of the nanoribbon 104 and the gate electrode material 108 may wrap around the gate dielectric material 112.

The gate electrode material 108 may include at least one P-type work function metal or N-type work function metal, depending on whether the transistor 110 is a PMOS transistor or an NMOS transistor (P-type work function metal used as the gate electrode material 108 when the transistor 110 is a PMOS transistor and N-type work function metal used as the gate electrode material 108 when the transistor 110 is an NMOS transistor). For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of two or more metal layers, where one or more metal layers are work function metal layers and at least one metal layer is a fill metal layer. Further layers may be included next to the gate electrode material 108 for other purposes, such as to act as a diffusion barrier layer or/and an adhesion layer.

In some embodiments, the gate dielectric material 112 may include one or more high-k dielectrics including any of the materials discussed herein with reference to the insulator material that may surround portions of the transistor 110. In some embodiments, an annealing process may be carried out on the gate dielectric material 112 during manufacture of the transistor 110 to improve the quality of the gate dielectric material 112. The gate dielectric material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and source/drain contacts of the transistor 110 and could be made of a low-k dielectric material, some examples of which have been provided above. A gate spacer may include pores or air gaps to further reduce its dielectric constant.

In some embodiments, e.g., when the transistor 110 is a storage transistor of a hysteretic memory cell (i.e., a type of memory that functions based on the phenomenon of hysteresis), the gate dielectric 112 may be replaced with, or complemented by, a hysteretic material. In some embodiments, a hysteretic material may be provided as a layer of a ferroelectric (FE) or an antiferroelectric (AFE) material. Such an FE/AFE material may include one or more materials which exhibit sufficient FE/AFE behavior even at thin dimensions, e.g., such as an insulator material at least about 10% of which is in an orthorhombic phase and/or a tetragonal phase. For example, such materials may be based on hafnium and oxygen (e.g., hafnium oxides), with various dopants added to ensure sufficient amount of an orthorhombic phase or a tetragonal phase. Some examples of such materials include hafnium zirconium oxide (HfZrO, also referred to as HZO), silicon-doped (Si-doped) hafnium oxide, germanium-doped (Ge-doped) hafnium oxide, aluminum-doped (Al-doped) hafnium oxide, and yttrium-doped (Y-doped) hafnium oxide. However, in other embodiments, any other materials which exhibit FE/AFE behavior at thin dimensions may be used to replace, or to complement, the gate dielectric 112, and are within the scope of the present disclosure. The FE/AFE material included in the gate stack 106 may have a thickness that may, in some embodiments, be between about 0.5 nanometers and 10 nanometers, including all values and ranges therein (e.g., between about 1 and 8 nanometers, or between about 0.5 and 5 nanometers). In other embodiments, a hysteretic material may be provided as a stack of materials that, together, exhibit hysteretic behavior. Such a stack may include, e.g., a stack of silicon oxide and silicon nitride. Unless specified otherwise, descriptions provided herein with respect to the gate dielectric 112 are equally application to embodiments where the gate dielectric 112 is replaced with, or complemented by, a hysteretic material.

Turning to the S/D regions 114 of the transistor 110, the S/D regions are highly doped, e.g., with dopant concentrations of about 10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. The channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

FIGS. 2A-2B provide perspective views of example IC devices 200 implementing nanoribbon-based capacitors, according to some embodiments of the present disclosure. As shown in each of FIGS. 2A and 2B, the IC device 200 may include the support structure 102 and a stack of two nanoribbons 104, individually labeled as nanoribbons 104-1 and 104-2, stacked above the support structure 102. Descriptions provided for the support structure 102 and the nanoribbon 104 with respect to FIG. 1 are applicable to the IC device 200 and, in the interest of brevity, are not repeated. Although not specifically shown in FIGS. 2A-2B, the IC device 200 may include additional nanoribbons 104 stacked above the nanoribbon 104-2, and/or additional stacks of two or more nanoribbons 104 provided over other portions of the support structure 102 (e.g., other stacks provided substantially parallel to the stack shown in FIGS. 2A-2B). Furthermore, although not specifically shown in FIGS. 2A-2B in order to not clutter the drawings, the nanoribbons 104 may be surrounded by and supported above the support structure 102 by an insulator material, which may include any suitable ILD material such as those described with reference to FIG. 1. In some embodiments, a structure having an insulator material 202 and a semiconductor material 204 may be provided between the support structure 102 and the nanoribbons 104, where the insulator material 202 may include any suitable ILD material such as those described with reference to FIG. 1 and the semiconductor material 204 may include a semiconductor material similar to that of the nanoribbons 104. In some such embodiments, a projection of the semiconductor material 204 onto a plane substantially parallel to the support structure 102 may substantially overlap with the analogous projections of the nanoribbons 104-1 and 104-2 (i.e., the nanoribbons 104 may be stacked directly above the semiconductor material 204). Such a structure may be a result of some conventional approaches to fabricating nanoribbon stacks. In other embodiments, the structure of the insulator material 202 and the semiconductor material 204 as shown in FIGS. 2A-2B may be absent.

As further shown in each of FIGS. 2A-2B, each of the nanoribbons 104 may include a first end 206-1 and an opposing second end 206-2. The some ends 206 of different nanoribbons 104 of a given stack may be said to "correspond" to one another in that they are the ends that are stacked above each other (i.e., the ends 206 of different nanoribbons 104 are corresponding if they are on the same side/end of the nanoribbon stack). For example, in FIGS. 2A-2B, the first end 206-1 of the nanoribbon 104-2 is stacked above the first end 206-1 of the nanoribbon 104-1 and, therefore, these two first ends 206-1 are corresponding ends of the nanoribbons 106-1 and 106-2. Similarly, the second end 206-2 of the nanoribbon 104-2 is stacked above the second end 206-2 of the nanoribbon 104-1 and, therefore, these two second ends 206-2 are corresponding ends of the nanoribbons 106-1 and 106-2.

In FIGS. 2A-2B, the nanoribbons 104-1 and 104-2 are nearest nanoribbons in a stack (i.e., there are no other nanoribbons in between and the nanoribbons 104-1 and 104-2 are consecutive nanoribbons in the nanoribbon stack), and, as such, one of them, e.g., the nanoribbon 104-1, may implement a first capacitor electrode of a capacitor 210, while the other one of them, e.g., the nanoribbon 104-2, may implement a second capacitor electrode. In some embodiments, the distance between the nanoribbons 104-1 and 104-2 may be between about 1 and 30 nanometers, including all values and ranges therein, e.g., between about 2 and 15 nanometers, or between about 2 and 10 nanometers.

As is typical for a capacitor, two capacitor electrodes of the capacitor 210 may be separated by an insulator material, referred to as a "capacitor insulator." In some embodiments, the capacitor insulator for of the capacitor 210 may be any suitable dielectric material conventionally used as capacitor insulators, such as high-k or low-k dielectric materials described above. In some embodiments, the capacitor insulator for of the capacitor 210 may be air or some other gaseous compound between the nanoribbons 104-1 and 104-2.

In some embodiments, instead of, or in addition to, a regular dielectric material used in conventional dielectric capacitors, the capacitor insulator of the capacitor 210 may include a hysteretic material or a hysteretic arrangement, which, together, may be referred to as a "hysteretic element." In such embodiments, the capacitor 210 may be described as a "hysteretic capacitor." The hysteretic element used as a capacitor insulator of the capacitor 210 may have a thickness that may, in some embodiments, be between about 0.5 nanometers and 10 nanometers, including all values and ranges therein (e.g., between about 1 and 8 nanometers, or between about 0.5 and 5 nanometers). Such may also be the distance between the nanoribbons 104-1 and 104-2 for various embodiments of the capacitor 210.

As used herein, a material or an arrangement may be described as hysteretic if it exhibits the dependence of its state on the history of the material (e.g., on a previous state of the material). Ferroelectric (FE) and antiferroelectric (AFE) materials are one example of hysteretic materials. Layers of different materials arranged in a stack to exhibit charge-trapping phenomena is one example of a hysteretic arrangement.

An FE or an AFE material is a material that exhibits, over some range of temperatures, spontaneous electric polarization, i.e., displacement of positive and negative charges from their original position, where the polarization can be reversed or reoriented by application of an electric field. In particular, an AFE material is a material that can assume a state in which electric dipoles from the ions and electrons in the material may form a substantially ordered (e.g., substantially crystalline) array, with adjacent dipoles being oriented in opposite (antiparallel) directions (i.e., the dipoles of each orientation may form interpenetrating sub-lattices, loosely analogous to a checkerboard pattern), while a FE material is a material that can assume a state in which all of the dipoles point in the same direction. Because the displacement of the charges in FE and AFE materials can be maintained for some time even in the absence of an electric field, such materials may be used to implement memory cells (e.g., the capacitor 210 with an FE/AFE material included in the capacitor insulator may be a storage capacitor of a memory cell). Because the current state of the electric dipoles in FE and AFE materials depends on the previous state, such materials are hysteretic materials. Memory technology where logic states are stored in terms of the orientation of electric dipoles in (i.e., in terms of polarization of) FE or AFE materials is referred to as "FE memory," where the term "ferroelectric" is said to be adopted to convey the similarity of FE memories to ferromagnetic memories, despite the fact that there is typically no iron (Fe) present in FE or AFE materials.

A stack of alternating layers of materials that is configured to exhibit charge-trapping is an example of a hysteretic arrangement. Such a stack may include as little as two layers of materials, one of which is a charge-trapping layer (i.e., a layer of a material configured to trap charges when a volage is applied across the material) and the other one of which is a tunnelling layer (i.e., a layer of a material through which the charge is to be tunneled to the charge-trapping layer). The tunnelling layer may include an insulator material such as a material that includes silicon and oxygen (e.g., silicon oxide), or any other suitable insulator. The charge-trapping layer may include a metal or a semiconductor material that is configured to trap charges. For example, a material that includes silicon and nitrogen (e.g., silicon nitride) may be used in/as a charge-trapping layer. Because the trapped charges may be kept in a charge-trapping arrangement for some time even in the absence of an electric field, such arrangements may be used to implement memory cells (e.g., the capacitor 210 with a charge-trapping arrangement included in the capacitor insulator may be a storage capacitor of a memory cell). Because the presence and/or the amount of trapped charges in a charge-trapping arrangement depends on the previous state, such arrangements are hysteretic arrangements. Memory technology where logic states are stored in terms of the amount of charge trapped in a hysteretic arrangement may be referred to as "charge-trapping memory."

Hysteretic memories have the potential for adequate non-volatility, short programming time, low power consumption, high endurance, and high speed writing. In addition, hysteretic memories may be manufactured using processes compatible with the standard CMOS technology. Therefore, over the last few years, these types of memories have emerged as promising candidates for many growing applications.

In some embodiments, the hysteretic element of the capacitor 210 may be provided as a layer of an FE or an AFE material between the nanoribbons 104-1 and 104-2. Such an FE/AFE material may include one or more materials that can exhibit sufficient FE/AFE behavior even at thin dimensions, e.g., such as an insulator material at least about 5%, e.g., at least about 7% or at least about 10%, of which is in an orthorhombic phase and/or a tetragonal phase (e.g., as a material in which at most about 95-90% of the material may be amorphous or in a monoclinic phase). For example, such materials may be based on hafnium and oxygen (e.g., hafnium oxides), with various dopants added to ensure sufficient amount of an orthorhombic phase or a tetragonal phase. Some examples of such materials include materials that include hafnium, oxygen, and zirconium (e.g., hafnium zirconium oxide (HfZrO, also referred to as HZO)), materials that include hafnium, oxygen, and silicon (e.g., silicon-doped (Si-doped) hafnium oxide), materials that include hafnium, oxygen, and germanium (e.g., germanium-doped (Ge-doped) hafnium oxide), materials that include hafnium, oxygen, and aluminum (e.g., aluminum-doped (Al-doped) hafnium oxide), and materials that include hafnium, oxygen, and yttrium (e.g., yttrium-doped (Y-doped) hafnium oxide). However, in other embodiments, any other materials which exhibit FE/AFE behavior at thin dimensions may be used as the hysteretic element of the capacitor 210, and are within the scope of the present disclosure.

In other embodiments, the hysteretic element of the capacitor 210 may be provided as a stack of alternating layers of materials that can trap charges. In some such embodiments, the stack may be a two-layer stack, where one layer is a charge-trapping layer and the other layer is a tunnelling layer. The tunnelling layer may include an insulator material such as a material that includes silicon and oxygen (e.g., silicon oxide), or any other suitable insulator. The charge-trapping layer may include an electrically conductive material such as a metal, or a semiconductor material. In some embodiments, the charge-trapping layer may include a material that includes silicon and nitrogen (e.g., silicon nitride). In general, any material that has defects that can trap charge may be used in/as a charge-trapping layer. Such defects are very detrimental to operation of logic devices and, therefore, typically, deliberate steps need to be taken to avoid presence of the defects. However, for memory devices, such defects are desirable because charge-trapping may be used to represent different memory states of a memory cell.

In some embodiments of the hysteretic element of the capacitor 210 being provided as a stack of alternating layers of materials that can trap charges, the stack may be a three-layer stack where an insulator material is provided on both sides of a charge-trapping layer. In such embodiments, a layer of an insulator material on one side of the charge-trapping layer may be referred to as a "tunnelling layer" while a layer of an insulator material on the other side of the charge-trapping layer may be referred to as a "field layer."

In various embodiments of the hysteretic element of the capacitor 210 being provided as a stack of alternating layers of materials that can trap charges, a thickness of each layer the stack may be between about 0.5 and 10 nanometers, including all values and ranges therein, e.g., between about 0.5 and 5 nanometers. In some embodiment of a three-layer stack, a thickness of each layer of the insulator material may be about 0.5 nanometers, while a thickness of the charge-trapping layer may be between about 1 and 8 nanometers, e.g., between about 2.5 and 7.5 nanometers, e.g., about 5 nanometers. In some embodiments, a total thickness of the hysteretic element of the capacitor 210 provided as a stack of alternating layers of materials that can trap charges (i.e., a hysteretic arrangement) may be between about 1 and 10 nanometers, e.g., between about 2 and 8 nanometers, e.g., about 6 nanometers.

FIGS. 2A and 2B differ in how the nanoribbons 104-1 and 104-2 may be extended to implement first and second capacitor interconnects. In particular, FIG. 2A illustrates an embodiment of the IC device 200 that includes a first extended portion 212-1 and a second extended portion 212-2 on opposite ends of respective first and second capacitor electrodes (i.e., on the opposite ends of the nanoribbon stack of the nanoribbons 104-1 and 104-2 as shown in FIG. 2A), while FIG. 2B illustrates an embodiment of the IC device 200 where the first extended portion 212-1 and the second extended portion 212-2 are on the same ends of respective first and second capacitor electrodes (i.e., on the same end of the nanoribbon stack of the nanoribbons 104-1 and 104-2 as shown in FIG. 2B).

As shown in FIG. 2A, the first extended portion 212-1 is attached to the first end 206-1 of the nanoribbon 104-1 so that the first extended portion 212-1 extends further than a corresponding end (i.e., the first end 206-1) of the nanoribbon 104-2, while the second extended portion 212-2 is attached to the second end 206-2 of the nanoribbon 104-2 so that the second extended portion 212-2 extends further than a corresponding end (i.e., the second end 206-2) of the nanoribbon 104-1. Unless specified otherwise, all references in the present disclosure with respect to any of the extended portions 212 extending an end 206 of a nanoribbon 104 refers to extensions in a direction along the longitudinal axis of the nanoribbon 104 (i.e., the extended portions 212 extend in the direction of the y-axis of the example coordinate system shown in the present drawings).

As also shown in FIG. 2A, a first interconnects 214-1 is electrically coupled to (e.g., is in conductive contact with) the first extended portion 212-1, and a second interconnect 214-2 is electrically coupled to (e.g., is in conductive contact with) the second extended portion 212-2. Extensions of the semiconductor materials of the individual nanoribbons 104-1 and 104-2 enable anode and cathode connections for the capacitor 210. For example, the first interconnect 214-1 may be a cathode terminal of the capacitor 210, while the second interconnect 214-2 may be an anode terminal of the capacitor 210, or vice versa.

In some embodiments, the first extended portion 212-1 may be an extension of the first nanoribbon 104-1 and the second extended portion 212-2 may be an extension of the second nanoribbon 104-2 as formed during manufacturing of the nanoribbon stack. In such embodiments, the extended portions 212 could have substantially the same material composition as the nanoribbons 104 that they extend, e.g., both an extended portion 212 and a nanoribbon 104 that it extends may include the same semiconductor material. In other embodiments, the extended portions 212 could have different materials than the nanoribbons 104 that they extend, e.g., an extended portion 212 and a nanoribbon 104 that it extends may include semiconductor materials of different material compositions, or any of the extended portions 212 may include an electrically conductive material.

In various embodiments, the interconnects 214 may be formed of any suitable electrically conductive materials. In general, in various embodiments, any of the electrically conductive materials described herein, e.g., the electrically conductive materials of the interconnects 214 or the electrically conductive materials which may be included in any of the extended portions 212, may include any suitable electrically conductive material, alloy, or a stack of multiple electrically conductive materials. In some embodiments, various electrically conductive materials described herein may include one or more metals or metal alloys, with metals such as copper, ruthenium, palladium, platinum, cobalt, nickel, hafnium, zirconium, titanium, tantalum, molybdenum, tungsten and aluminum. In some embodiments, various electrically conductive materials described herein may include one or more electrically conductive alloys, oxides (e.g., conductive metal oxides), carbides (e.g., hafnium carbide, zirconium carbide, titanium carbide, tantalum carbide, and aluminum carbide), or nitrides (e.g., hafnium nitride, zirconium nitride, titanium nitride, tantalum nitride, and aluminum nitride) of one or more metals. In some embodiments, any of the interconnects 214 may be an electrically conductive via, as is illustrated in FIGS. 2A-2B. However, in other embodiments, any of the interconnects 214 may be an electrically conductive line.

In some embodiments, the extended portions 212 could have substantially the same width (i.e., a dimension measured along the x-axis of the example coordinate system shown in the present drawings) as the nanoribbons 104 that they extend. In other embodiments, their widths may be different. In some embodiments, the extended portions 212 could have substantially the same thickness (i.e., a dimension measured along the z-axis of the example coordinate system shown in the present drawings) as the nanoribbons 104 that they extend. In other embodiments, their thicknesses may be different. In some embodiments, the length of any of the extended portions 212 (i.e., a dimension measured along the y-axis of the example coordinate system shown in the present drawings) may be between about 10 and 500 nanometers, including all values and ranges therein, e.g., between about 15 and 100 nanometers, or between about 20 and 50 nanometers.

The IC device 200 shown in FIG. 2B is substantially the same as that shown in FIG. 2A, except that the second extended portion 212-2 is attached to the first end 206-1 of the nanoribbon 104-2 (i.e., both the first and second extended portions 212-1 and 212-2 are on the corresponding ends of their respective nanoribbons 104-1 and 104-2). In some embodiments, the extended portion 212 of the lower nanoribbon 104 (i.e., the one closer to the support structure 102), in the example shown in FIG. 2B - the nanoribbon 104-1, may extend further than the extended portion 212 of the higher nanoribbon 104 (i.e., the one farther away from the support structure 102), in the example shown in FIG. 2B - the nanoribbon 104-2. In other words, the length of the extended portion 212 of the lower nanoribbon 104 may be greater than the length of the extender portion 212 of the higher nanoribbon 104. Such embodiments may advantageously enable a stair-case like arrangement of the interconnects 214 to the extended portions 212 that extend on the same side of different nanoribbons 104.

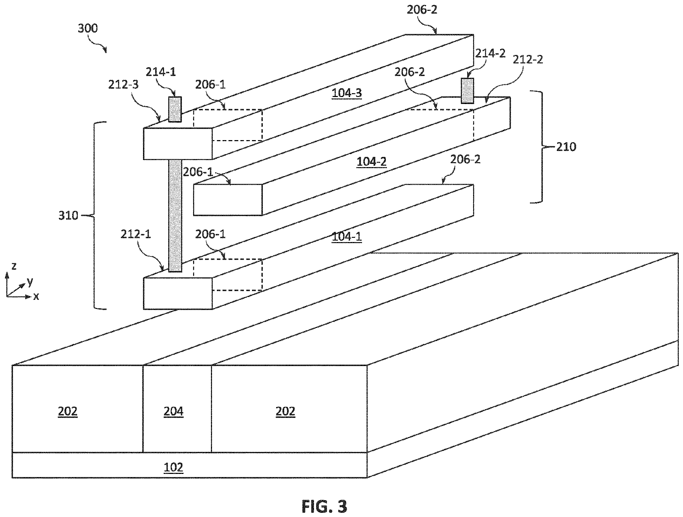

FIG. 3 provides a perspective view of an example IC device 300 extending a nanoribbon-based capacitor arrangement to a three-nanoribbon arrangement with a common connection between two of the three nanoribbons, according to some embodiments of the present disclosure. The IC device 300 is similar to the IC device 200 shown in FIG. 2A, in that it includes the capacitor 210 as described with reference to FIG. 2A, except that the IC device 300 extends the nanoribbon-based capacitor 210 to a three-nanoribbon arrangement by also showing a third nanoribbon 104-3, stacked above the second nanoribbon 104-2 (i.e., the nanoribbon 104-2 is between the nanoribbons 104-1 and 104-3). Similar to the nanoribbons 104-1 and 104-2, the nanoribbon 104-3 includes a first end 206-1, corresponding to the first end 206-1 of the nanoribbons 104-1 and 104-2, and further includes a second end 206-2, corresponding to the second end 206-2 of the nanoribbons 104-1 and 104-2. As shown in FIG. 3, the IC device 300 further includes a third extended portion 212-3, attached to the first end 206-1 of the nanoribbon 104-3 so that the third extended portion 212-3 extends further than a corresponding end (i.e., the first end 206-1) of the nanoribbon 104-2. An electrical interconnect may also be coupled to (e.g., be in conductive contact with) the third extended portion 212-3, which interconnect is realized in the IC device 300 by extending the first interconnect 214-1 to also couple to the third extended portion 212-3. Thus, as shown in FIG. 3, the first interconnect 214-1 may be electrically continuous to electrically couple to both, the first extended portion 212-1 and the third extended portion 212-3. For example, the first interconnect 214-1 may be implemented as a relatively deep via that extends through both the first extended portion 212-1 and the third extended portion 212-3. Such an arrangement realizes a component 310, that includes a common connection, e.g., a common anode connection, to the nanoribbons 104-1 and 104-3 by means of the first interconnect 214-1 coupled to the extended portions 212-1 and 212-3, and further includes an individual connection, e.g., an individual cathode connection, to the nanoribbon 104-2 in between the nanoribbons 104-1 and 104-3 by means of the second interconnect 214-2 coupled to the extended portion 212-2.

Descriptions provided above with respect to the first extended portion 212-1 (e.g., in terms of materials and/or dimensions) are applicable to the third extended portion 212-3 and, therefore, are not repeated. In various embodiments, the lengths of the first and third extended portions 212 may be substantially the same or may be different.

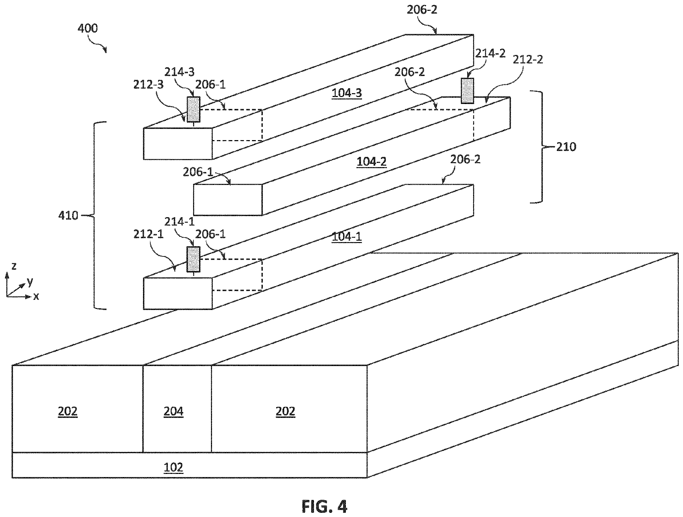

FIG. 4 provides a perspective view of an example IC device 400 extending a nanoribbon-based capacitor arrangement to realize a BJT 410 using a three-nanoribbon arrangement, according to some embodiments of the present disclosure. The IC device 400 is similar to the IC device 300 shown in FIG. 3, in that it includes a three-nanoribbon arrangement with the extended portions 212-1, 212-2, and 212-3 as shown in FIG. 3, except that the IC device 400 includes individual interconnects for coupling to the first extended portion 212-1 and the third extended portion 212-3. As shown in FIG. 4, the IC device 400 includes the first interconnect 214-1 that is electrically coupled to the first extended portion 212-1 and further includes a third interconnect 214-3 that is electrically coupled to the third extended portion 212-3. Such an arrangement may realize a nanoribbon-based BJT 410, where the first interconnect 214-1 is a collector contact of the BJT 410, the second interconnect 214-2 is an emitter contact of the BJT 410, and the third interconnect 214-3 is a base contact of the BJT 410.

The IC devices 100, 200, 300, and 400 illustrated in the present drawings, do not represent an exhaustive set of IC devices in which nanoribbon-based capacitors as described herein may be implemented, but merely provide examples of such devices. In various embodiments, any of the features described with reference to one of the IC devices of FIGS. 1-4 may be combined with any of the features described with reference to another one of the IC devices of FIGS. 1-4. For example, even though FIGS. 3 and 4 illustrate that the first and third extended portions 212-1, 212-3 are provided at the first end 206-1 of the nanoribbons 104-1 and 104-3, while the second extended portion 212-2 is provided at the second end 206-2 of the nanoribbons 104-2, in other embodiments, any pair of extended portions 212 of two consecutive nanoribbons 104 may extend from the same end 206 of these nanoribbons 104, as shown in FIG. 2B. For example, in some embodiments of the BJT 410, all three extended portions 212 may extend from the first end 206-1 of the nanoribbons 104-1, 104-2, and 104-3, where three interconnects 214 may, in some embodiments, be arranged in a stair-case manner as shown in FIG. 2B but extended to three nanoribbons 104. In another example, any of the nanoribbons 104 of any of the IC devices 200, 300, and 400 according to any combination of FIGS. 2-4 may further include one or more nanoribbon-based transistors 110 as shown in FIG. 1.

Although particular arrangements of materials are discussed with reference to FIGS. 1-4, intermediate materials may be included in various portions of these figures. Note that FIGS. 1-4 are intended to show relative arrangements of some of the components therein, and that various device components of these figures may include other components that are not specifically illustrated, e.g., various interfacial layers or various additional components or layers. Additionally, although some elements of the IC devices are illustrated in FIGS. 1-4 as being planar rectangles or formed of rectangular solids, this is simply for ease of illustration, and embodiments of various ones of these elements may be curved, rounded, or otherwise irregularly shaped as dictated by, and sometimes inevitable due to, the manufacturing processes used to fabricate semiconductor device assemblies. Therefore, descriptions of various embodiments of IC devices implementing nanoribbon-based capacitors, provided herein, are equally applicable to embodiments where various elements of the resulting IC devices look different from those shown in the figures due to manufacturing processes used to form them.

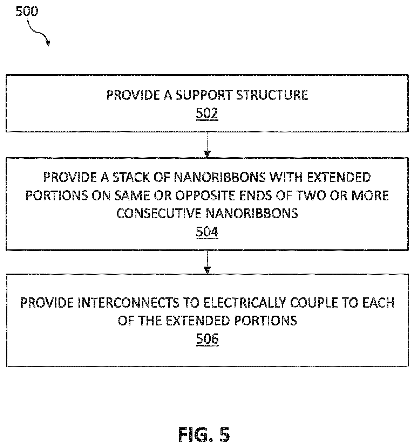

The IC devices implementing one or more nanoribbon-based capacitors as described herein may be manufactured using any suitable techniques. FIG. 5 provides a flow diagram of an example method 500 of manufacturing an IC device with one or more nanoribbon-based capacitors, according to some embodiments of the present disclosure. However, other examples of manufacturing any of the IC devices described herein, as well as larger devices and assemblies that include such structures (e.g., as shown in FIGS. 6-9) are also within the scope of the present disclosure.

In FIG. 5, although the operations are illustrated once each and in a particular order, the operations may be performed in any suitable order and repeated as desired. For example, one or more operations may be performed in parallel to manufacture, substantially simultaneously, multiple nanoribbon-based capacitors as described herein. In another example, the operations may be performed in a different order to reflect the structure of a particular device assembly in which one or more nanoribbon-based capacitors as described herein will be included. In addition, the example manufacturing method shown in FIG. 5 may include other operations not specifically shown in this drawing, such as various cleaning or planarization operations as known in the art. For example, in some embodiments, the support structure 102, as well as layers of various other materials subsequently deposited thereon/in, may be cleaned prior to, after, or during any of the processes of the methods shown in FIG. 5, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the IC devices/assemblies described herein may be planarized prior to, after, or during any of the processes of the methods shown in FIG. 5, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

The method 500 may begin with a process 502 in which a support structure is provided, to serve as a base for building an IC device implementing one or more nanoribbon-based capacitors. The support structure provided in the process 502 may be the support structure 102 as described above.

The method 500 may include a process 504 in which a stack of nanoribbons is provided over the support structure provided in the process 502, where at least two or more of consecutive nanoribbons may include extended portions on the same or opposite ends of the nanoribbons. The stack of nanoribbons provided in the process 504 may include the nanoribbons 104-1 and 104-2 as shown in FIGS. 2-4 and may further include the nanoribbon 104-3 as shown in FIGS. 3-4. The extended portions provided in the process 504 may include the extended portions 212-1 and 212-2 as shown in FIGS. 2-4, may further include the extended portion 212-3 as shown in FIGS. 3-4, and may be provided according to other combinations of the embodiments of FIGS. 2-4 not specifically shown in the present drawings (e.g., three extended portions 212 provided on three consecutive nanoribbons 104 may all extend from the corresponding ends of these nanoribbons, in accordance with a combination of the embodiment illustrated in FIG. 2B with the embodiment illustrated in FIG. 4). Any known techniques for forming nanoribbons may be used to provide the nanoribbons in the process 504. Extended portions as described herein may either be formed as integral (i.e., monolithic) to the nanoribbons as the nanoribbons are being formed, e.g., using suitable patterning techniques, or may be provided after the nanoribbons are formed.

The method 500 may include a process 506 in which interconnects are provided to electrically couple to each of the extended portions provided in the process 504. The interconnects provided in the process 506 may include the interconnects 214-1 and 214-2 as shown in FIGS. 2-4 and may further include the interconnect 214-3 as shown in FIGS. 3-4. Any known techniques for forming interconnects may be used to provide the interconnects in the process 506.

IC devices implementing nanoribbon-based capacitors, as disclosed herein may be included in any suitable electronic device or component. FIGS. 6-9 illustrate various examples of devices and components that may include one or more IC devices implementing nanoribbon-based capacitors as disclosed herein.

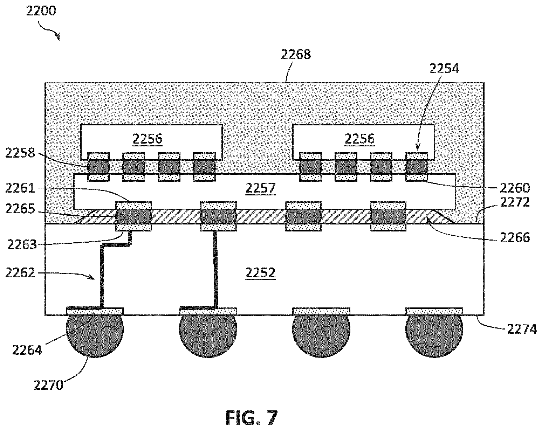

FIG. 6 are top views of a wafer 2000 and dies 2002 that may include one or more IC devices implementing nanoribbon-based capacitors in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 7. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more IC devices implementing nanoribbon-based capacitors as described herein). After the fabrication of the semiconductor product is complete (e.g., after manufacture of one or more IC devices implementing nanoribbon-based capacitors as described herein, e.g., after manufacture of any embodiments of the IC devices as described with reference to FIGS. 2-4), the wafer 2000 may undergo a singulation process in which each of the dies 2002 is separated from one another to provide discrete "chips" of the semiconductor product. In particular, devices that include one or more IC devices implementing nanoribbon-based capacitors as disclosed herein may take the form of the wafer 2000 (e.g., not singulated) or the form of the die 2002 (e.g., singulated). The die 2002 may include one or more transistors (e.g., nanoribbon-based transistors as described herein), diodes resistors, capacitors (e.g., nanoribbon-based capacitors as described herein), and other IC components as well as, optionally, supporting circuitry to route electrical signals to the IC devices implementing nanoribbon-based capacitors and various other IC components. In some embodiments, the wafer 2000 or the die 2002 may implement an electrostatic discharge (ESD) protection device, an RF FE device, a memory device (e.g., a SRAM device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more IC devices implementing nanoribbon-based capacitors in accordance with any of the embodiments disclosed herein. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

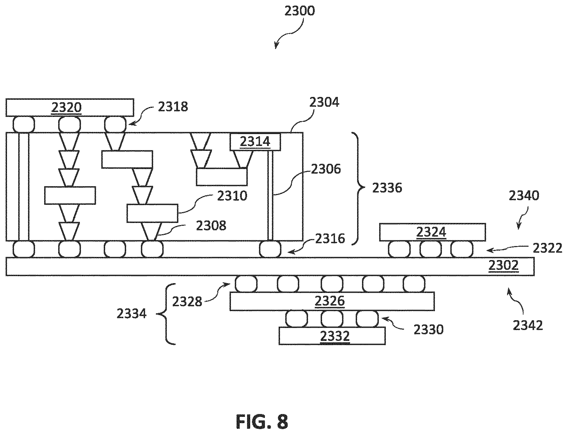

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein and may include any of the embodiments of an IC device implementing nanoribbon-based capacitors, e.g., any embodiments of the IC devices as described with reference to FIGS. 2-4. In embodiments in which the IC package 2200 includes multiple dies 2256, the IC package 2200 may be referred to as a multi-chip package (MCP). Importantly, even in such embodiments of an MCP implementation of the IC package 2200, one or more IC devices implementing nanoribbon-based capacitors may be provided in a single chip, in accordance with any of the embodiments described herein. The dies 2256 may include circuitry to perform any desired functionality. For example, one or more of the dies 2256 may be logic dies, including one or more IC devices implementing nanoribbon-based capacitors as described herein, one or more of the dies 2256 may be memory dies (e.g., high bandwidth memory) with one or more IC devices implementing nanoribbon-based capacitors, etc. In some embodiments, any of the dies 2256 may include one or more IC devices implementing nanoribbon-based capacitors, e.g., as discussed above; in some embodiments, at least some of the dies 2256 may not include any IC devices implementing nanoribbon-based capacitors.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more IC devices implementing nanoribbon-based capacitors in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing nanoribbon-based capacitors in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include one or more IC devices implementing nanoribbon-based capacitors in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6), an IC device (e.g., any embodiments of the IC devices as described with reference to FIGS. 2-4), or any other suitable component. In particular, the IC package 2320 may include one or more IC devices implementing nanoribbon-based capacitors as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. In some embodiments, the IC devices implementing nanoribbon-based capacitors as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

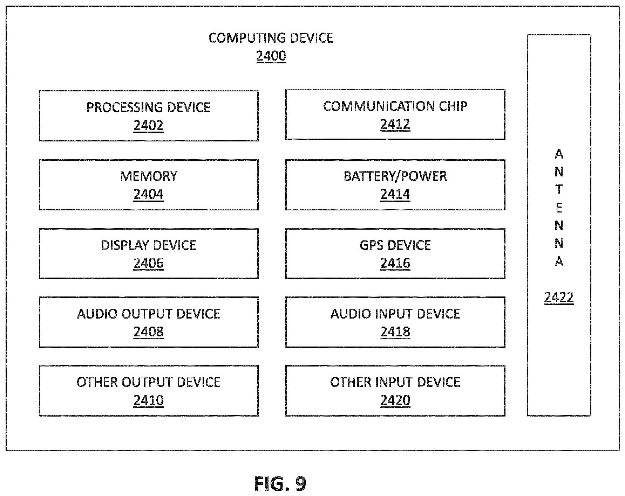

FIG. 9 is a block diagram of an example computing device 2400 that may include one or more components with one or more IC devices implementing nanoribbon-based capacitors in accordance with any of the embodiments disclosed herein. For example, any suitable ones of the components of the computing device 2400 may include a die (e.g., the die 2002 of FIG. 6) including one or more IC devices implementing nanoribbon-based capacitors in accordance with any of the embodiments disclosed herein. Any of the components of the computing device 2400 may include an IC device (e.g., any embodiment of the IC devices of FIGS. 2-4) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408 but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices implementing nanoribbon-based capacitors as described herein may be particularly advantageous for use as part of ESD circuits protecting power amplifiers, low-noise amplifiers, filters (including arrays of filters and filter banks), switches, or other active components. In some embodiments, IC devices implementing nanoribbon-based capacitors as described herein may be used in PMICs, e.g., as a rectifying diode for large currents. In some embodiments, IC devices implementing nanoribbon-based capacitors as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device that includes a support structure (e.g., a substrate, a wafer, a die, or a chip); a nanoribbon stack, including a plurality of nanoribbons stacked above one another over the support structure, the plurality of nanoribbons including at least a first nanoribbon and a second nanoribbon that are consecutive nanoribbons in the nanoribbon stack; a first extended portion, attached to an end of the first nanoribbon so that the first extended portion extends further than a corresponding end (i.e., the end on the same side of the nanoribbon stack) of at least one other nanoribbon of the plurality of nanoribbons; a second extended portion, attached to an end of the second nanoribbon so that the second extended portion extends further than a corresponding end of at least one other nanoribbon of the plurality of nanoribbons; a first interconnect, electrically coupled to (e.g., in conductive contact with) the first extended portion; and a second interconnect, electrically coupled to (e.g., in conductive contact with) the second extended portion.

Example 2 provides the IC device according to example 1, where the first extended portion includes a semiconductor material. The same is applicable to the second extended portion and the second nanoribbon.

Example 3 provides the IC device according to example 2, where the semiconductor material of the first extended portion is different from a semiconductor material of the first nanoribbon. The same is applicable to the second extended portion and the second nanoribbon.

Example 4 provides the IC device according to example 1, where at least one of the first extended portion and the second extended portion includes an electrically conductive material.

Example 5 provides the IC device according to any one of the preceding examples, where a width of the first extended portion is different from a width of the first nanoribbon. The same is applicable to the second extended portion and the second nanoribbon.

Example 6 provides the IC device according to any one of the preceding examples, where a thickness of the first extended portion is different from a thickness of the first nanoribbon. The same is applicable to the second extended portion and the second nanoribbon.

Example 7 provides the IC device according to any one of the preceding examples, where a length of the first extended portion is between about 10 and 500 nanometers, including all values and ranges therein, e.g., between about 15 and 100 nanometers, or between about 20 and 50 nanometers.

Example 8 provides the IC device according to any one of the preceding examples, where at least one of the first interconnect and the second interconnect is a conductive via.

Example 9 provides the IC device according to any one of the preceding examples, where at least one of the first interconnect and the second interconnect is a conductive line.

Example 10 provides the IC device according to any one of the preceding examples, where the second extended portion and the first extended portion are on opposite ends of the nanoribbon stack, e.g., as shown in FIG. 2A.

Example 11 provides the IC device according to any one of the preceding examples, where the second extended portion and the first extended portion are on a single end of the nanoribbon stack, e.g., as shown in FIG. 2B.

Example 12 provides the IC device according to example 11, where, when the first nanoribbon is closer to the support structure than the second nanoribbon, the first extended portion extends further than the second extended portion (i.e., the length of the first extended portion is greater than the length of the second extended portion), or, when the second nanoribbon is closer to the support structure than the first nanoribbon, the second extended portion extends further than the first extended portion (i.e., the length of the second extended portion is greater than the length of the first extended portion).

Example 13 provides the IC device according to any one of the preceding examples, where a distance between the first nanoribbon and the second nanoribbon is between about 1 and 30 nanometers, including all values and ranges therein, e.g., between about 2 and 15 nanometers, or between about 2 and 10 nanometers.

Example 14 provides the IC device according to any one of the preceding examples, where the plurality of nanoribbons further includes a third nanoribbon, the second nanoribbon and the third nanoribbon are consecutive nanoribbons in the nanoribbon stack (i.e., the second nanoribbon is between the first and the third nanoribbons), and the IC device further includes a third extended portion, attached to an end of the third nanoribbon so that the third extended portion extends further than a corresponding end (i.e., the end on the same side of the nanoribbon stack) of at least one other nanoribbon of the plurality of nanoribbons.

Example 15 provides the IC device according to example 14, where the first interconnect is further electrically coupled to (e.g., in conductive contact with) the third extended portion, e.g., as shown in FIG. 3.

Example 16 provides the IC device according to example 15, where the first interconnect is a conductive via that extends though the first extended portion and the third extended portion.

Example 17 provides the IC device according to example 14, further including a third interconnect, electrically coupled to (e.g., in conductive contact with) the third extended portion, e.g., as shown in FIG. 4.

Example 18 provides the IC device according to example 17, where the first interconnect is a collector contact of a BJT, the second interconnect is an emitter contact of the BJT, and the third interconnect is a base contact of the BJT.

Example 19 provides the IC device according to any one of examples 14-18, where the first extended portion and the third extended portion are on a first side of the nanoribbon stack, and the second extended portion is on an opposing second side of the nanoribbon stack, e.g., as shown in FIG. 3 and FIG. 4.

Example 20 provides the IC device according to any one of examples 14-19, where a length of the first extended portion is different from a length of the third extended portion.

Example 21 provides an IC device that includes a support structure (e.g., a substrate, a wafer, a die, or a chip); a nanoribbon stack, including a plurality of nanoribbons stacked above one another over the support structure, the plurality of nanoribbons including at least a first nanoribbon and a second nanoribbon that are consecutive nanoribbons in the nanoribbon stack; a first interconnect, electrically coupled to (e.g., in conductive contact with) an end of the first nanoribbon; and a second interconnect, electrically coupled to (e.g., in conductive contact with) an end of the second nanoribbon, where the first nanoribbon is between the support structure and the second nanoribbon, the end of the first nanoribbon and the end of the second nanoribbon are at a same end of the nanoribbon stack, and the end of the first nanoribbon extends further than the end of the second nanoribbon.

Example 22 provides the IC device according to example 21, where the plurality of nanoribbons further includes a third nanoribbon, the second nanoribbon is between the first nanoribbon and the third nanoribbon, the end of the second nanoribbon extends further than an end of the third nanoribbon, and the end of the third nanoribbon and the end of the second nanoribbon are at the same end of the nanoribbon stack.

Example 23 provides the IC device according to example 22, where the first interconnect is further electrically coupled to (e.g., in conductive contact with) the end of the third nanoribbon.

Example 24 provides the IC device according to example 22, further including a third interconnect, electrically coupled to (e.g., in conductive contact with) the end of the third nanoribbon.

Example 25 provides the IC device according to any one of examples 21-24, where at least one of the first interconnect and the second interconnect is a conductive via.

Example 26 provides an IC device that includes a support structure (e.g., a substrate, a wafer, a die, or a chip); a nanoribbon stack, including a plurality of nanoribbons stacked above one another over the support structure, the plurality of nanoribbons including at least a first nanoribbon and a second nanoribbon that are consecutive nanoribbons in the nanoribbon stack; a first interconnect, electrically coupled to (e.g., in conductive contact with) an end of the first nanoribbon; and a second interconnect, electrically coupled to (e.g., in conductive contact with) an end of the second nanoribbon, where the first nanoribbon is between the support structure and the second nanoribbon, and the end of the first nanoribbon and the end of the second nanoribbon are at opposite ends of the nanoribbon stack.

Example 27 provides the IC device according to example 26, where the plurality of nanoribbons further includes a third nanoribbon, the second nanoribbon is between the first nanoribbon and the third nanoribbon, and the end of the second nanoribbon and an end of the third nanoribbon are at opposite ends of the nanoribbon stack.

Example 28 provides the IC device according to example 27, where the first interconnect is further electrically coupled to (e.g., in conductive contact with) the end of the third nanoribbon.

Example 29 provides the IC device according to example 27, further including a third interconnect, electrically coupled to (e.g., in conductive contact with) the end of the third nanoribbon.

Example 30 provides the IC device according to any one of examples 26-29, where at least one of the first interconnect and the second interconnect is a conductive via.

Example 31 provides an IC package that includes an IC die, including an IC device according to any one of the preceding examples; and a further component, coupled to the IC die.

Example 32 provides the IC package according to example 31, where the further component is one of a package substrate, an interposer, or a further IC die.

Example 33 provides an electronic device that includes a carrier substrate; and one or more of the IC devices according to any one of the preceding examples and/or the IC package according to any one of the preceding examples, coupled to the carrier substrate.

Example 34 provides the electronic device according to example 33, where the carrier substrate is a motherboard.

Example 35 provides the electronic device according to example 33, where the carrier substrate is a PCB.

Example 36 provides the electronic device according to any one of examples 33-35, where the electronic device is a wearable electronic device (e.g., a smart watch) or handheld electronic device (e.g., a mobile phone).

Example 37 provides the electronic device according to any one of examples 33-36, where the electronic device further includes one or more communication chips and an antenna.

Example 38 provides the electronic device according to any one of examples 33-37, where the electronic device is memory device.

Example 39 provides the electronic device according to any one of examples 33-37, where the electronic device is one of an RF transceiver, a switch, a power amplifier, a low-noise amplifier, a filter, a filter bank, a duplexer, an upconverter, or a downconverter of an RF communications device, e.g., of an RF transceiver.

Example 40 provides the electronic device according to any one of examples 33-37, where the electronic device is a computing device.

Example 41 provides the electronic device according to any one of examples 33-40, where the electronic device is included in a base station of a wireless communication system.

Example 42 provides the electronic device according to any one of examples 33-40, where the electronic device is included in a UE device (i.e., a mobile device) of a wireless communication system.

Example 43 provides a method of fabricating an IC device. The method includes providing a nanoribbon stack, where the nanoribbon stack includes a plurality of nanoribbons stacked above one another over a support structure, where the plurality of nanoribbons includes at least a first nanoribbon and a second nanoribbon that are consecutive nanoribbons in the nanoribbon stack; a first extended portion as a portion at an end of the first nanoribbon so that the first extended portion extends further than a corresponding end of at least one other nanoribbon of the plurality of nanoribbons; and a second extended portion as a portion at an end of the second nanoribbon so that the second extended portion extends further than a corresponding end of at least one other nanoribbon of the plurality of nanoribbons. The method further includes providing a first interconnect, electrically coupled to the first extended portion; and providing a second interconnect, electrically coupled to the second extended portion.

Example 44 provides the method according to example 43, where at least one of the first interconnect and the second interconnect is a conductive via.

Example 45 provides the method according to examples 43 or 44, further including processes for fabricating the IC device according to any one of the preceding examples.

Example 46 provides the method according to any one of examples 43-45, further including processes for fabricating the IC package according to any one of the preceding examples.

Example 47 provides the method according to any one of examples 43-46, further including processes for fabricating the electronic device according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a support structure; and
a nanoribbon stack, including a plurality of nanoribbons stacked above one another over the support structure, the plurality of nanoribbons including at least a first nanoribbon and a second nanoribbon that are consecutive nanoribbons in the nanoribbon stack;
a first extended portion at an end of the first nanoribbon, where the first extended portion extends further than a corresponding end of at least one other nanoribbon of the plurality of nanoribbons;
a second extended portion at an end of the second nanoribbon, where the second extended portion extends further than a corresponding end of at least one other nanoribbon of the plurality of nanoribbons;
a first interconnect, electrically coupled to the first extended portion; and
a second interconnect, electrically coupled to the second extended portion.

2. The IC device according to claim 1, wherein at least one of the first extended portion and the second extended portion includes a semiconductor material.

3. The IC device according to claim 1, wherein at least one of the first extended portion and the second extended portion includes an electrically conductive material.

4. The IC device according to any one of the preceding claims, wherein:
a width of the first extended portion is different from a width of the first nanoribbon, or
a thickness of the first extended portion is different from a thickness of the first nanoribbon.

5. The IC device according to any one of the preceding claims, wherein at least one of the first interconnect and the second interconnect is a conductive via.

6. The IC device according to any one of the preceding claims, wherein the second extended portion and the first extended portion are on opposite ends of the nanoribbon stack.

7. The IC device according to any one of the preceding claims, wherein:
the second extended portion and the first extended portion are on a single end of the nanoribbon stack,
the first nanoribbon is closer to the support structure than the second nanoribbon, and
the first extended portion extends further than the second extended portion.

8. The IC device according to any one of the preceding claims, wherein a distance between the first nanoribbon and the second nanoribbon is between about 1 and 30 nanometers.

9. The IC device according to any one of the preceding claims, wherein:
the plurality of nanoribbons further includes a third nanoribbon,
the second nanoribbon and the third nanoribbon are consecutive nanoribbons in the nanoribbon stack, and
the IC device further includes a third extended portion, attached to an end of the third nanoribbon so that the third extended portion extends further than a corresponding end of at least one other nanoribbon of the plurality of nanoribbons.

10. The IC device according to claim 9, wherein the first interconnect is further electrically coupled to the third extended portion.

11. The IC device according to claim 10, wherein the first interconnect is a conductive via that extends though the first extended portion and the third extended portion.

12. The IC device according to claim 9, 10 or 11, further including a third interconnect, electrically coupled to the third extended portion.

13. The IC device according to claim 12, wherein the first interconnect is a collector contact of a bipolar junction transistor (BJT), the second interconnect is an emitter contact of the BJT, and the third interconnect is a base contact of the BJT.

14. The IC device according to any one of claims 9-13, wherein the first extended portion and the third extended portion are on a first side of the nanoribbon stack, and the second extended portion is on an opposing second side of the nanoribbon stack.

15. The IC device according to any one of claims 9-14, wherein a length of the first extended portion is different from a length of the third extended portion.
